Europäisches Patentamt

European Patent Office

Office européen des brevets

(11) Veröffentlichungsnummer: **0 387 685**
**A2**

## (12) EUROPÄISCHE PATENTANMELDUNG

(21) Anmeldenummer: **90104371.1**

(22) Anmeldetag: **07.03.90**

(51) Int. Cl.⁵: **H03M 1/60, H03K 7/06**

(30) Priorität: **17.03.89 DE 3908849**

(43) Veröffentlichungstag der Anmeldung:
**19.09.90 Patentblatt 90/38**

(84) Benannte Vertragsstaaten:
**CH DE ES FR GB IT LI SE**

(71) Anmelder: **Siemens Aktiengesellschaft**
**Wittelsbacherplatz 2**
**D-8000 München 2(DE)**

(72) Erfinder: **Hagen, Hartwig, Dipl.-Ing. (FH)**
**Paul-Gossen-Strasse 34**
**D-8520 Erlangen(DE)**

(54) **Verfahren zur Spannungs-Frequenz-Wandlung und Einrichtung zur Durchführung des Verfahrens.**

(57) Mit dem Verfahren zur Spannungs-Frequenz-Wandlung und einer Einrichtung zur Durchführung des Verfahrens läßt sich mit einfachen Mitteln eine äußerst schnelle und hochgenaue Digitalisierung eines analogen Eingangssignals ($U_E$) bei großem Frequenzhub erreichen. Eine in den positiven Bereich angehobene Eingangsspannung ($U_E^{\pm}$) wird integriert und als integrierte Spannung ($U_J$) mit einer in äquidistanten Schritten veränderlichen Referenzspannung ($U_A$) verglichen. Wenn die integrierte Spannung ($U_J$) größer ist als die Referenzspannung ($U_A$) wird ein Binärsignal logisch "1" erzeugt, ist sie kleiner, entsteht ein Binärsignal logisch "0". Damit entsteht eine der Eingangsspannung ($U_E$) proportionale Impulsfolgefrequenz. Mit jedem Impuls (P) wird die Referenzspannung ($U_A$) inkrementiert, so daß diese treppenförmig der integrierten Spannung ($U_J$) folgt.

FIG 4

EP 0 387 685 A2

Die Erfindung bezieht sich auf ein Verfahren zur Spannungs-Frequenz-Wandlung sowie auf eine Einrichtung zur Durchführung des Verfahrens. In der Meßwerterfassung kann in vielen Fällen ein Spannungs-Frequenz-Wandler einen Analog-Digital- oder Digital-Analog-Wandler ersetzen. Ein Spannungs-Frequenz-Wandler gibt anstelle des binärparallelen Codewortes eine der Eingangsspannung proportionale Frequenz an seinem Ausgang ab. Ein Vorteil liegt darin, daß man den analogen Teil einer Schaltung leicht vom digitalen Teil isolieren kann. Deshalb werden Spannungs-Frequenz Wandler in den verschiedensten Gebieten der Elektrotechnik und Elektronik verwendet. Beispielsweise lassen sich bei der Regelung von Elektromotoren die Strom- bzw. Spannungsistwerte durch Wandlung in eine dem Strom- bzw. Spannungsistwert proportionale Folge von Impulsen leicht in ein digitales Regelungskonzept integrieren.

Wegen der in vielen Anwendungsfällen geforderten Kleinheit der Abmessungen eines solchen Spannungs-Frequenz-Wandlers kann nicht immer auf herkömmliche Spannungs-Frequenz-Wandler zurückgegriffen werden.

Eine weitere Forderung nach äußerst schneller und hochgenauer Digitalisierung des Eingangssignals bei großem Frequenzhub und bei möglichst geringen Kosten kann ebenfalls nicht durch herkömmliche Spannungs-Frequenz-Wandler erfüllt werden.

Zur Einbindung der Spannungs- bzw. Stromistwerterfassung in ein digitales Regelungskonzept ist es wünschenswert, das kontinuierliche Signal am Ort seiner Erfassung in eine proportionale Frequenz zu wandeln und beispielsweise in Form von Impul sen mit unterschiedlicher Impuls-Folgefrequenz zu übertragen. Damit ist eine hohe Störsicherheit gewährleistet, da für die Weiterverarbeitung der Impulse nur geringe Ansprüche an die Impulsform gestellt werden.

Aufgabe der Erfindung ist es, einen schnellen, hochgenauen Spannungs-Frequenz-Wandler mit großem Frequenzhub mit einfachen Mitteln zu realisieren. Diese Aufgabe wird durch ein Verfahren zur Spannungs-Frequenz-Wandlung nach folgenden Verfahrensschritten gelöst:

a) Eine Eingangsspannung, die einen beliebigen zeitlichen Verlauf haben kann, wird durch Verknüpfung mit einer Konstante in den positiven Bereich angehoben,

b) die angehobene Eingangsspannung wird integriert und als integrierte Spannung mit einer Referenzspannung verglichen, die in äquidistanten Schritten veränderlich ist, wobei ein Binärsignal erzeugt wird,

b1) das dem Binärzustand logisch "1" entspricht, wenn die integrierte Spannung größer ist als die Referenzspannung,

b2) das dem Binärzustand logisch "0" entspricht, wenn die integrierte Spannung kleiner ist als die Referenzspannung,

c) durch jedes Signal logisch "1" wird die Referenzspannung um einen äquidistanten Spannungshub erhöht,

d) bei Erreichen eines vorgegebenen oberen Grenzwertes werden die Verfahrensschritte a) bis c) wiederholt, wobei die Integration der angehobenen Eingangsspannung reversiert, die Referenzspannung um einen äquidistanten Spannungshub erniedrigt und das Binärsignal invertiert wird,

e) bei Erreichen eines vorgegebenen unteren Grenzwertes werden die Verfahrensschritte a) bis c) wiederholt,

f) die durch den Wechsel des jeweiligen Binärzustandes logisch "0" und logisch "1" erzeugten Impulse werden in einem Zeitintervall gezählt.

Eine Ausbildung der Erfindung ist dadurch gekennzeichnet, daß eine Folge von Zusatzimpulsen erzeugt wird, wenn der äquidistante Spannungshub der Referenzspannung

a) im Falle des Schrittes c) nicht dazu führt, daß die Referenzspannung größer ist als die integrierte Spannung,

b) im Falle des Schrittes d) nicht dazu führt, daß die Referenzspannung kleiner ist, als die integrierte Spannung.

Durch diese Maßnahme, die als Impulsüberwachung bezeichnet werden kann, wird die Betriebssicherheit des Verfahrens verbessert. Wenn beispielsweise aus irgendeinem Grund die integrierte Spannung zu stark ansteigt, kann es vorkommen, daß die Referenzspannung die integrierte Spannung nicht mehr "einholen" kann. In diesem Fall wird durch die von der Impulsüberwachung mit hoher Frequenz abgegebenen Zusatzimpulse die Referenzspannung schneller weitergeschaltet.

Eine weitere Ausbildung der Erfindung ist dadurch gekennzeichnet, daß aus den erzeugten Impulsen eine Gleichspannung und aus der Gleichspannung sowie aus der angehobenen Eingangsspannung eine Differenzspannung gebildet wird, wobei aus der Summe der Differenzspannung und der angehobenen Eingangsspannung eine Regelspannung erzeugt wird, mit der der jeweils verwendete Integrator beaufschlagt wird.

Diese Ausbildung der Erfindung dient der Fehlerregelung und kann beispielsweise dann verwendet werden, wenn hohe Anforderungen an die Genauigkeit der Spannungs-Frequenz-Wandlung gestellt werden, oder wenn preiswertere und damit in den meisten Fällen ungenauere Bauteile für eine Einrichtung zur Durchführung des Verfahrens verwendet werden sollen.

Zur Durchführung des Verfahrens bietet sich eine Einrichtung zur Spannungs-Frequenz-Wandlung an wie sie den Ansprüchen 4 bis 7 zugrundeliegt.

Ein Ausführungsbeispiel der Erfindung ist in der Zeichnung dargestellt und wird im folgenden näher erläutert. Dabei zeigen:

FIG 1 ein Prinzipschaltbild zur Durchführung des Verfahrens zur Spannungs-Frequenz-Wandlung,

FIG 2 das Diagramm einer integrierten Spannung sowie einer Referenzspannung,

FIG 3 ein Impulsdiagramm,

FIG 4 das Blockschaltbild einer Einrichtung zur Spannungs-Frequenz-Wandlung,

FIG 5 ein Spannungsdiagramm der integrierten Spannung sowie der Referenzspannung,

FIG 6 bis 8 Impulsdiagramme,

FIG 9 ein Blockschaltbild einer Einrichtung zur Spannungs-Frequenz-Wandlung mit Fehlerregelung.

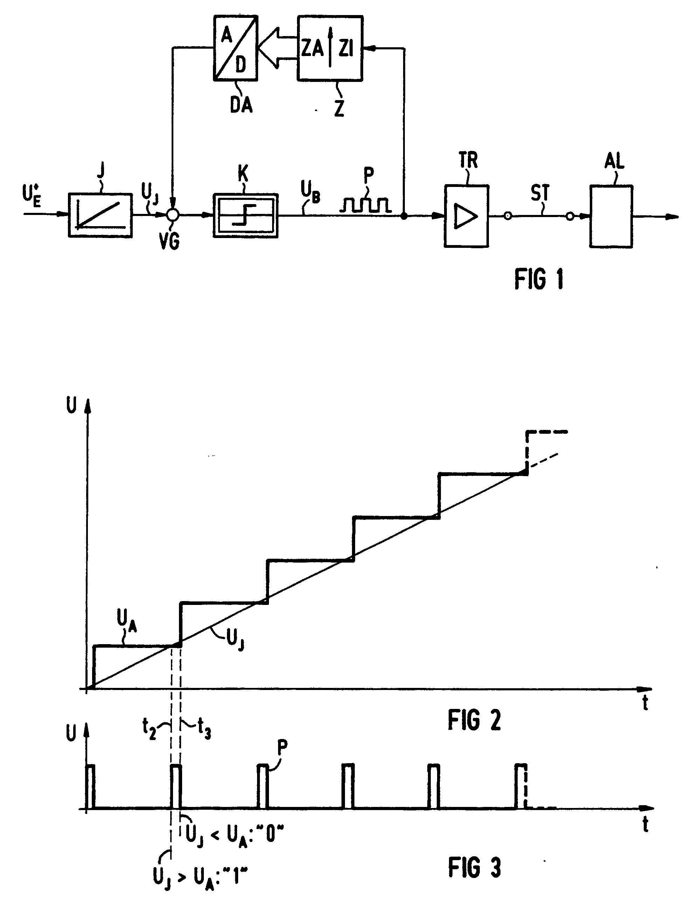

Anhand des Blockschaltbildes (regelungstechnisches Strukturbild) gemäß FIG 1 und der Diagramme gemäß den Figuren 2 und 3 soll das Verfahren zur Spannungs-Frequenz-Wandlung zunächst prinzipiell beschrieben werden.

Das Blockschaltbild gemäß FIG 1 besteht aus einem Integrator J, einem Vergleicher VG, einem Komparator K, einer Treiberstufe TR, einer Übertragungsstrecke ST, sowie einer Auswertelogik AL. Der Ausgang des Komparators K ist mit dem Eingang ZI eines Zählers Z verbunden. Der Zähler Z ist durch einen nach oben weisenden Pfeil als Aufwärtszähler gekennzeichnet. Der Ausgang ZA des Zählers Z ist mit dem Digitaleingang eines Digital-Analog-Wandlers verbunden, dessen Analogausgang A auf den zweiten Eingang des Vergleichers VG geführt ist.

Der Vergleicher VG und der Komparator K sind in den entsprechenden Figuren der Übersichtlichkeit halber getrennt gezeichnet. Der Vergleich er VG kann jedoch auch integraler Bestandteil des Komparators K sein, der in diesem Fall zwei Eingänge aufweisen würde.

Die Richtung des Signalflusses im Blockschaltbild ist durch Pfeile angegeben. Damit sind auch die jeweiligen Ein- und Ausgänge eines jeden Blok-kes festgelegt.

Eine in den positiven Bereich angehobene Ein-gangsspannung $U_E^\pm$ , wird an den Eingang des Integrators J gelegt. Es sei angenommen, daß die-se Eingangsspannung proportional dem Stromist-wert eines Servomotors ist, der zur Regelung des Servomotors verwendet werden soll. Da für die Regelung lediglich der Mittelwert der Eingangsspannung von Interesse ist, wird diese Eingangsspannung zunächst integriert und als integrierte Spannung $U_J$ an den Eingang des Vergleichers VG gegeben. Am Vergleicher VG liegt gleichzeitig eine Referenzspannung $U_A$ an, die mit der integrierten Spannung $U_J$ verglichen wird.

Zu einem Zeitpunkt t = 0 sei die Referenzspannung sowie die integrierte Spannung gleich Null. Aufgrund der am Integrierer J anliegenden Eingangsspannung $U_E$ steigt die integrierte Spannung $U_J$ zur Zeit t größer 0 an. Damit wird am Vergleicher VG die integrierte Spannung $U_J$ größer als die Referenzspannung $U_A$. Dies führt dazu, daß am Ausgang des Komparators K ein Binärsignal $U_B$ = logisch "1" erscheint. Dieses Signal gelangt an den Eingang ZI des Zählers Z und schaltet diesen einen Zählschritt weiter, worauf am Ausgang A des Digital-Analog-Wandlers DA die Referenzspannung $U_A$ um einen äquidistanten Spannungshub erhöht wird. Damit ist, wie in FIG 2 ersichtlich, die Referenzspannung $U_A$ größer als die integrierte Spannung $U_J$ und der Komparator K wechselt sein Ausgangssignal von logisch "1" in logisch "0". Damit ist, wie in FIG 3 ersichtlich, ein erster Impuls P am Ausgang des Komparators K erzeugt worden.

Im weiteren Verlauf bleibt die Referenzspannung $U_A$ zunächst konstant, da der Zähler Z vom Binärsignal $U_B$ = logisch "0" nicht beeinflußt wird. Die integrierte Spannung $U_J$ steigt jedoch weiter an, wie in FIG 2 ersichtlich, bis sie zum Zeitpunkt $t_2$ wieder größer als die Referenzspannung $U_A$ ist. Dies führt wiederum dazu, daß am Ausgang des Komparators K ein Signal $U_B$ = logisch "1" anliegt und der Zähler Z über seinen Zählimpulseingang ZI wieder um einen Zählschritt weitergeschaltet wird. Die Referenzspannung $U_A$ steigt damit wieder um einen äquidistanten Spannungshub, so daß zum Zeitpunkt $t_3$ der Komparator K seinen binären Ausgangszustand wieder wechselt. Am Ausgang des Komparators K entsteht also immer ein Signal $U_B$ = logisch "1", wenn $U_J$ größer $U_A$
und ein Signal
$U_B$ = logisch "0", wenn $U_J$ kleiner $U_A$.

Aus den Digrammen der FIG 2 und 3 ist ersichtlich, daß bei einer geradlinig ansteigenden Spannung $U_J$ eine Referenzspannung $U_A$ in Form einer bezüglich der Zeit und der Spannung äquidistanten Treppenkurve entsteht. Dies hat, wie in FIG 3 ersichtlich, Impulse P mit konstanten Pulspausen zur Folge. Es ist jedoch leicht erkennbar, daß bei einer größeren Steigung der integrierten Spannung $U_J$ die Impulse P näher aneinanderliegen und umgekehrt. Die Summe der Impulse P pro Zeiteinheit und damit deren Frequenz, ist für beliebigen Spannungsverlauf der Spannung $U_J$ direkt proportional zur Eingangsspannung $U_E^\pm$

Im Beispiel gemäß FIG 1 werden die Impulse P über eine Treiberstufe T und eine Übertragungsstrecke ST an eine Auswertelogik AL gegeben. An die Übertragungsstrecke ST brauchen dabei keine hohe Anforderungen gestellt werden. Die Übertragung einer hohen Impulsfolgefrequenz (beispielsweise 20 MHz) ist unkritisch, da an die Impulsform nur geringe Ansprüche gestellt werden, so daß die Qualität des Verfahrens nicht beeinträchtigt wird, solange die Impulse P von der Auswertelogik AL gerade noch erkannt werden können. Falls tatsächlich ein Impuls nicht mehr erkannt werden sollte, entsteht kein bleibender Fehler, da lediglich die Genauigkeit einer Zählung während einer Zeiteinheit beeinfluß wird. Insofern weist das Verfahren eine hohe Störsicherheit auf.

Die Impulsfolgefrequenz des Spannungs-Frequenz-Wandlers kann leicht ausgewertet werden, indem sie in einem Zähler der in der Auswertelogik AL integriert sein kann, (z.B. 16 Bitzähler) aufsummiert wird. Dieser Zähler kann Bestandteil einer digitalen Regeleinrichtung sein, so daß das Ergebnis der Spannungs-Frequenz-Wandlung unmittelbar für die Regelung herangezogen werden kann. Die nachfolgende Verarbeitung der Impulsfolgefrequenz kann freizügig variieren in Bezug auf die Wahl der Abtastzeitpunkte und verschiedene Arten der Mittelwertbildung. Vorteilhafterweise könnte die Mittelwertbildung über ein sogenanntes gleitendes Fenster erfolgen. Dabei wird die Anzahl der Impulse in einem Zeitintervall T gezählt, wobei die Zählung periodisch in einem kürzeren Zeitintervall als dem Zeitintervall T wiederholt wird.

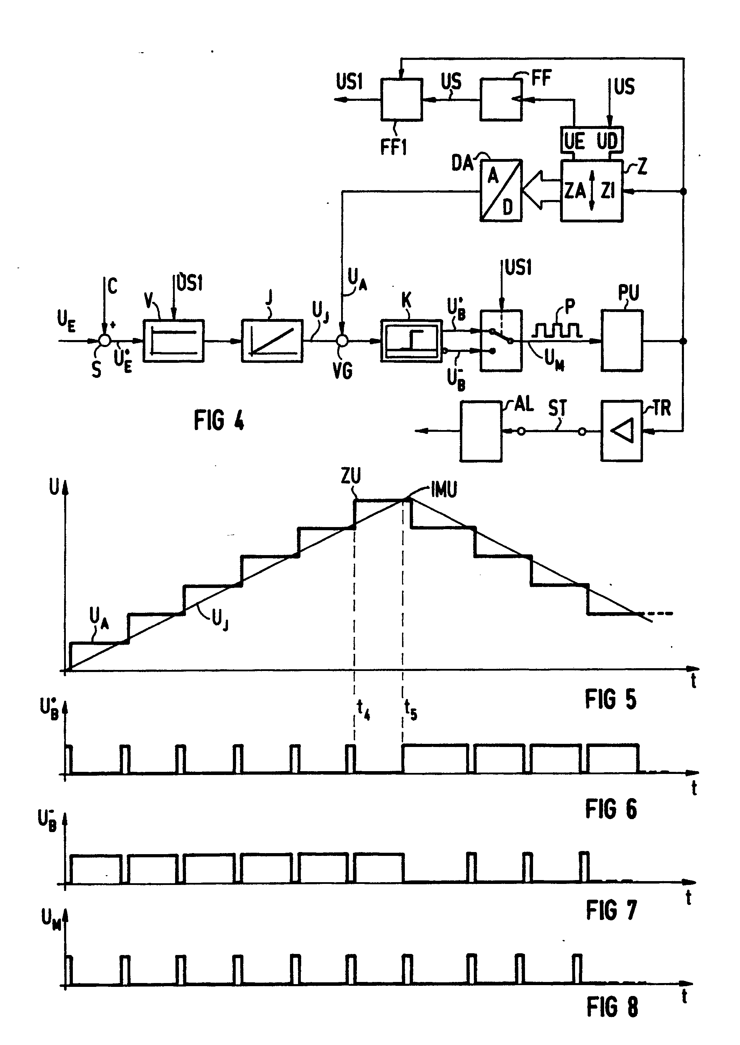

Bei der bisherigen Beschreibung der prinzipiellen Wirkungsweise der Spannungs-Frequenz-Wandlung wurde von der idealen Annahme ausgegangen, daß sowohl der Integrator J als auch der Zähler Z und der Digital-Analog-Wandler DA keine oberen Grenzwerte aufweisen. Dies ist bei realen Bauteilen natürlich nicht der Fall. Es müssen deshalb Maßnahmen getroffen werden, die die Funktion des Verfahrens auch dann gewährleisten, wenn der Integrator J, oder der Zähler Z, oder der Digital-Analog-Wandler DA an ihre oberen oder unteren Grenzen stoßen. Diese Maßnahmen werden im folgenden anhand des Blockschaltbildes der FIG 4 sowie der Diagramme der Figuren 5 bis 8 beschrieben.

FIG 4 zeigt ein Blockschaltbild einer Einrichtung zur Spannungs-Frequenz-Wandlung. Zusätzlich zu den bereits in FIG 1 beschriebenen Blöcken weist das Blockschaltbild gemäß FIG 4 vor dem Integrator J einen Summierer S und einen Verstärker V auf. Der Summierer S verfügt über zwei Eingänge von denen ein erster Eingang mit einer Eingangsspannung $U_E$ und ein zweiter Eingang mit einer Konstanten C beaufschlagt ist. Die Konstante C ist dabei so berechnet, daß die Eingangsspannung $U_E$ in den positiven Bereich $U_E^+$ angehoben wird. Die Konstante K könnte aber selbstverständlich auch so berechnet sein, daß die Eingangsspannung $U_E$ in den negativen Bereich transformiert wird. Bei der Transformation der Eingangsspannung $U_E$ kommt es lediglich darauf an, daß über ihren gesamten zeitlichen Verlauf kein Polaritätswechsel stattfindet.

Der Verstärker V weist zusätzlich zu seinem Verstärkereingang, der mit der angehobenen Eingangsspannung $U_E^+$ beaufschlagt ist, einen weiteren Eingang für ein erstes Umschaltsignal US1 auf. Über diesen Eingang und mittels des ersten Umschaltsignals US1 kann der Verstärker V auf positive oder negative Verstärkung geschaltet werden.

Der Komparator K des Blockschaltbildes gemäß FIG 4 weist zwei Ausgänge für die Binärsignale $U_B^+$ bzw. $U_B^-$ auf, wobei der zweite Ausgang durch einen Kreis als zum ersten Ausgang invertierter gekennzeichnet ist. Die beiden Ausgänge des Komparators K führen auf zwei Eingänge eines Multiplexers M der durch das Sybmbol eines Wechselschalters gekennzeichnet ist. Dieser Wechselschalter kann ebenfalls über das Umschaltsignal US ausgelöst werden. Dem Multiplexer M nachgeschaltet ist eine Impulsüberwachungseinheit PU, auf die später noch eingegangen wird.

Der Zähler Z der FIG 4 ist im Gegensatz zum Zähler Z der FIG 1 als Auf-Abwärtszähler ausgeführt, was durch den Doppelpfeil symbolisiert ist. Zusätzlich zum Zählimpulseingang ZI und zum Zählerausgang ZA verfügt der Zähler Z über einen Zählrichtungs-Umschalteingang UD (up/down) sowie über einen Überlaufsignalausgang UE. Über den Überlaufausgang UE kann ein Signal ausgegeben werden, wenn der Zähler Z eine vorgebbare Zählgrenze erreicht hat. Dieses Überlaufsignal UE wird an den Eingang eines bistabilen Schaltgliedes FF (Flip-Flop) gegeben, an dessen Ausgang ein Umschaltsignal US beispielsweise als Binärsignal erscheint. Das Umschaltsignal US wird zum einen direkt an den Um schalteingang UD des Zählers Z gegeben, zum anderen auf einen ersten bistabilen Schalter FF1, wo es das zeitverzögerte erste Umschaltsignal US1 auslöst.

Der obere Grenzwert des Zählers Z ist dabei so vorzugeben, daß er erreicht wird, bevor der Integrator J seine obere physikalische Integrationsgrenze erreicht hat. Selbstverständlich ist auch der Digital-Analog-Wandler DA so auszulegen, daß er für den gesamten vorgegebenen Zählbereich des Zählers Z geeignet ist.

Anhand der in den Figuren 5 bis 8 gezeigten Diagramme sei nun die Wirkungsweise einer Einrichtung gemäß des Blockschaltbildes der FIG 4 beschrieben. Die Integration der angehobenen Eingangsspannung $U_E^+$ sowie die Weiterschaltung der Referenzspannung $U_A$ über den Zähler Z und den Digital-Analog-Wandler DA erfolgt nach dem anhand der FIG 1 bis 3 beschriebenen Prinzip, bis der Zähler Z seinen vorgegebenen oberen Grenzwert erreicht hat. Mit Erreichen dieses oberen Grenzwertes wird über den Überlaufausgang UE des Zählers Z das Überlaufsignal an den bistabilen Schalter FF gegeben, der daraufhin an seinem Ausgang den Binärzustand wechselt. Dieser Wechsel des Binärzustandes gelangt als Umschaltsignal US unmittelbar an den Umschalteingang UD des Zählers Z. Damit wird, wie in FIG 5 ersichtlich, zum Zeitpunkt $t_4$ die Zählerumschaltung ZU herbeigeführt, so daß der Zähler seine Zählrichtung wechselt. Der Zähler wird also ab dem nächsten Zählimpuls von seinem oberen Grenzwert in äquidistanten Schritten abwärts zählen. Vom Zeitpunkt $t_4$ bis zum Zeitpunkt $t_5$ ändert sich jedoch die Integrationsrichtung des Integrators und damit die integrierte Spannung $U_J$ noch nicht. Das Umschaltsignal US gelangt nämlich nicht direkt an den Verstärker V und an den Multiplexer M, sondern wird durch den ersten bistabilen Schalter FF1 um einen Zählimpuls verzögert. Zu diesem Zweck ist ein weiterer Eingang des ersten bistabilen Schalters FF1 mit dem Ausgang des Multiplexers M bzw. mit dem Ausgang einer Pulsüberwachung PU verbunden. Durch die Verzögerung des ersten Umschaltsignals US1 gegenüber dem Umschaltsignal US wird erreicht, daß der Richtungswechsel der integrierten Spannung $U_J$ am Ausgang des Integrators J - der durch die Umschaltung des Verstärkers V bewirkt wird - erst dann vorgenommen wird, wenn die Referenzspannung $U_A$ bereits in der Gegenrichtung um einen äquidistanten Spannungshub vorgeeilt ist. Auch der Multiplexer M schaltet bis zum Zeitpunkt $t_5$ noch das nichtinvertierte Signal $U_B^+$ des Komparators K an seinen Ausgang durch. Die Wirkungsweise des Verfahrens und der Einrichtung gemäß dem Blockschaltbild der FIG 4 ist also bis zum Zeitpunkt $t_4$ nicht verschieden von der anhand der Figuren 1 bis 3 bereits beschriebenen Wirkungsweise.

Zum Zeitpunkt $t_5$ (IMU = Integrator-Multiplexer-Umschaltung),also um einen Zählimpuls verzögert, (FIG 5) gelangt das Umschaltsignal US1 (FIG 4) auch an den Verstärker V und an den Multiplexer M. Die Verstärkung des Verstärkers V wird durch das Umschaltsignal US1 umgeschaltet, d.h. der Verstärker arbeitet jetzt mit negativer Verstärkung. Damit kehrt sich ebenfalls die Integrationsrichtung des Integrators J um, wie in FIG 5 ersichtlich. Gleichzeitig mit der Umschaltung des Verstärkers V wurde der Multiplexer M durch das Umschaltsignal US1 umgeschaltet, so daß jetzt das am invertierten Ausgang des Komparators K anliegende Signal $U_B^-$ an den Multiplexer M gelangt.

Um Mißverständissen vorzubeugen, sei darauf hingewiesen, daß das Binärsignal $U_B^+$ beide Binärzustände, also sowohl den Zustand logisch "1", als auch logisch "0" annehmen kann. Entsprechendes gilt für das Binärsignal $U^-$. Die hochgestellten Indizes " + " und "-" bezeichnen lediglich den nichtinvertierten bzw. den invertierten Ausgang des Komparators K.

Der Signalverlauf der Signale $U_B^+$ bzw. des dazu invertierten Signals $U_B^-$ am Ausgang des Komparators K ist in den Figuren 6 bzw. 7 dargestellt. Bis einschließlich des Zeitpunktes $t_4$ erscheint am Ausgang des Multiplexers der Signalverlauf $U_B^+$ von FIG 6. Nach dem Zeitpunkt $t_4$ erscheint am Ausgang des Multiplexers M der Signalverlauf $U_B^-$ wie er in FIG 7 dargestellt ist. Damit wird am Ausgang des Multiplexers M der in FIG 8 gezeigte Signalverlauf des Signals $U_M$ erzeugt.

Wenn der Zähler wieder seine untere Grenze erreicht hat, wird wieder über den Umschaltausgang UE des Zählers Z der bistabile Schalter FF angesteuert, dessen binäres Ausgangssignal wieder wechselt und als Umschaltsignal US zunächst die Zählrichtung des Zählers umsteuert, um dann den Verstärkers V wieder auf positive Verstärkung zu schalten und den Multiplexer M wieder mit dem Ausgang $U_B^+$ des Komparators zu verbinden, wobei das Verfahren von vorne beginnt.

Zur Verbesserung der Betriebssicherheit des Verfahrens und der Einrichtung zur Spannungs-Frequenz-Wandlung ist - wie in FIG 4 dargestellt - dem Multiplexer M eine Pulsüberwachung PU nachgeschaltet. Diese Pulsüberwachung PU schaltet bei störungsfreien Betrieb das Ausgangssignal $U_B^+$, $U_B^-$ des Multiplexers M unverändert an seinen Ausgang durch. Es kann jedoch vorkommen, daß beispielsweise der Komparator K aus irgendeinem Grund nicht rechtzeitig zurückschaltet. Dies könnte beispielsweise dann der Fall sein, wenn die integrierte Spannung $U_J$ sehr schnell ansteigt, so daß sie von der Referenzspannung $U_A$ nicht mehr eingeholt werden kann. Wenn die Maximalfrequenz des Spannungs-Frequenz-Wandlers beispielsweise 20 MHz beträgt, dann dürfte die gesamte Impulsbreite 50 Nanosekunden (ns) nicht überschreiten, d.h. der Komparator K müßte innerhalb 50 ns zurückschalten. Ist dies nicht der Fall, so löst das Fehlen eines Impulses P bei der Pulsüberwachung PU eine Pulsfolge maximaler Frequenz aus, wodurch der Zähler Z und als Folge davon die Referenzspannung $U_A$ mit maximaler Geschwindigkeit hochgeschaltet wird, so daß die integrierte Spannung $U_J$ wieder eingeholt wird. Wenn dies der Fall ist, ist die Bedingung für das Zurückschalten des Komparators K wieder erreicht und der normale Betriebsfall wieder hergestellt.

Die Pulsüberwachung PU inklusive der Erzeugung der Impulsfolge maximaler Frequenz ist auf einfache Weise in den Multiplexer M integrierbar. Mit der Pulsüberwachung PU ist es auch möglich, bei gleicher Maximalfrequenz langsamere und damit billigere Bauteile, z.B. für den Digital-Analog-Wandler DA zu wählen. Dadurch würde jedoch für die höheren Frequenzen die Auflösung etwas geringer.

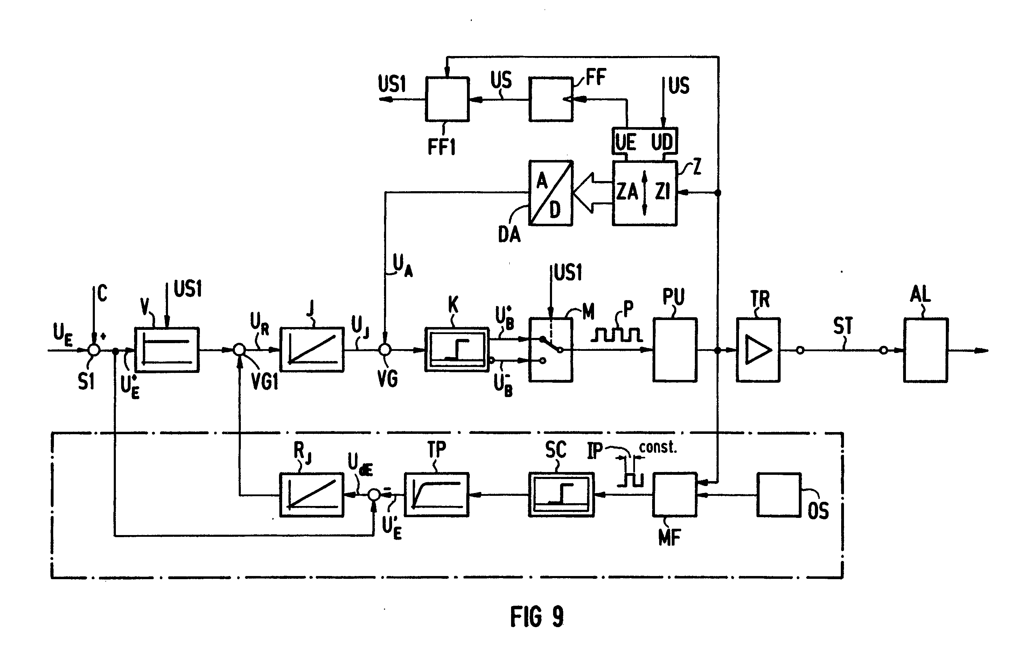

Die Betriebssicherheit des Spannungs-Frequenz-Wandlers, die beispielsweise durch die Güte der Bauteile beeinflußt wird, läßt sich durch eine Fehlerregelung, wie sie im folgenden anhand der FIG 9 beschrieben ist, weiter verbessern.

FIG 9 zeigt ein Blockschaltbild einer Einrichtung zur Spannungs-Frequenz-Wandlung mit Fehlerregelung. Die Regelstrecke für die Fehlerregelung ist durch ein gestrichelt gezeichnetes Rechteck hervorgehoben. Der übrige Teil des Blockschaltbildes entspricht bis auf einen Vergleicher VG1 zwischen dem Verstärker V und dem Integrierer J, dem bereits aus FIG 4 bekannten Blockschaltbild.

Die Regelstrecke zur Fehlerregelung besteht - von rechts nach links - aus einem Oszillator OS, einem monostabilen Schalter MF (Monoflop), einem Präzisionsschalter SC, einem Tiefpaß TP, einem zweiten Vergleicher VG2, und einem Regler $R_J$. Das Monoflop MF bildet zusammen mit dem Oszillator OS ein sogenanntes Präzisions-Monoflop.

An den Eingang des Monoflops MF gelangen die vom Spannungs-Frequenz-Wandler erzeugten Impulse P. Bei jedem dieser ankommenden Impulse P greift sich, das Monoflop MF genau eine Periode des Oszillators heraus und erzeugt einen Präzisionsimpuls IP mit jeweils konstanter Impulsbreite. Dieser Präzisionsimpuls IP wird an den Eingang des Präzisionsschalters SC gegeben. Der Präzisionsschalter SC gibt die ankommenden Präzisionsimpulse mit genau definierter Spannung an seinen Ausgang. Das Präzisions- Monoflop und der Präzisionsschalter SC erzeugen also einen Präzisionsimpuls mit genau definierter Fläche. Dieser Präzisionsimpuls wird an den Eingang des Tiefpasses TP gegeben, an dessen Ausgang nunmehr eine der Pulsfolgefrequenz proportionale Gleichspannung $U_E'$ erscheint, die bei idealer Spannungs-Frequenz-Wandlung gleich der angehobenen Eingangsspannung $U_E^\pm$ sein müßte. Diese Gleichspannung $U_E'$ wird am Vergleich er VG2 mit der angehobenen Eingangsspannung $U_E^\pm$ verglichen und eine entstehende Differenzspannung $U_{dE}$ wird über einen Regler $R_J$ an dem Vergleicher VG1 der Regelstrecke aufgeschaltet. Am Ausgang des Vergleichers VG1 entsteht damit eine Regelspannung $U_R$ aus der Differenz der Differenzspannung $U_{dE}$ und der angehobenen und verstärkten Eingangsspannung $U_E^\pm$

Mit dieser Fehlerregelung arbeitet das Verfahren bzw. die Einrichtung auch dann noch mit ausreichender Genauigkeit, wenn Bauteile geringerer Güte verwendet werden.

**Ansprüche**

1. Verfahren zur Spannungs-Frequenz-Wandlung nach folgenden Verfahrensschritten:

a) Eine Eingangsspannung ($U_E$), die einen beliebigen zeitlichen Verlauf haben kann, wird durch Verknüpfung mit einer Konstante (C) in den positiven Bereich angehoben,

b) die angehobene Eingangsspannung ($U_E^\pm$) wird integriert und als integrierte Spannung ($U_J$) mit einer Referenzspannung ($U_A$) verglichen, die in äquidistanten Schritten veränderlich ist, wobei ein Binärsignal ($U_B$) erzeugt wird,

b1) das dem Binärzustand logisch "1" entspricht, wenn die integrierte Spannung ($U_J$) größer ist als die Referenzspannung ($U_A$),

b2) das dem Binärzustand logisch "0" entspricht, wenn die integrierte Spannung ($U_J$) kleiner ist als die Referenzspannung ($U_A$),

c) durch jedes Signal logisch "1" wird die Referenzspannung ($U_A$) um einen äquidistanten Spannungshub erhöht,

d) bei Erreichen eines vorgegebenen oberen Grenzwertes werden die Verfahrensschritte a) bis c) wiederholt, wobei die Integration der angehobenen Eingangsspannung ($U_E^\pm$) reversiert, die Referenzspannung ($U_A$) um einen äquidistanten Spannungshub erniedrigt und das Binärsignal ($U_B$) invertiert wird,

e) bei Erreichen eines vorgegebenen unteren Grenzwertes werden die Verfahrensschritte a) bis c) wiederholt,

f) die durch den Wechsel des jeweiligen Binärzustandes logisch "0" und logisch "1" erzeugten Impulse (P) werden in einem Zeitintervall (T) gezählt.

2. Verfahren nach Anspruch 1, **dadurch gekennzeichnet**, daß eine Folge von Zusatzimpulsen (P) erzeugt wird, wenn der äquidistante Spannungshub der Referenzspannung ($U_A$) a) im Falle des Schrittes c) nicht dazu führt, daß die Referenzspannung ($U_A$) größer ist als die integrierte Spannung ($U_J$), b) im Falle des Schrittes d) nicht dazu führt, daß die Referenzspannung ($U_A$) kleiner ist, als die integrierte Spannung ($U_J$).

3. Verfahren nach einem der vorstehenden Ansprüche, **dadurch gekennzeichnet**, daß aus den erzeugten Impulsen (P) eine Gleichspannung ($U_E'$) und aus der Gleichspannung ($U_E'$) sowie aus der angehobenen Eingangsspannung ($U_E^\pm$) eine Differenzspannung ($U_{dE}$) gebildet wird, wobei aus der Summe der Differenzspannung ($U_{dE}$) und der angehobenen Eingangsspannung ($U_E^\pm$) eine Regelspannung ($U_R$) erzeugt wird, mit der der jeweils verwendete Integrator (J) beaufschlagt wird.

4. Einrichtung zur Spannungs-Frequenz-Wandlung bestehend aus:

a) Einem Verstärker (V) mit durch ein Umschaltsignal (US) umschaltbarer positiver und negativer Verstärkung, dessen Ausgang mit dem Eingang eines Integrators (J) verbunden ist,

b) einem Komparator (K) mit mindestens zwei Eingängen, wobei ein erster Eingang mit dem Ausgang des Integrators (J) und ein zweiter Eingang mit dem Analogausgang (A) eines Digital-Analog-Wandlers (DA) verbunden ist, wobei der Komparator (K) über einen ersten Ausgang ein Binärsignal ($U_B^+$) logisch "1" oder logisch "0" in Abhängigkeit von der Differenz der Eingangssignale ($U_J, U_A$) und über einen zweiten Ausgang das invertierte Binärsignal ($U_B^-$) des ersten Ausgangs ausgeben kann,

c) einem Multiplexer (M) dessen Eingänge mit den Ausgängen des Komparators (K) verbunden sind und der in Abhängigkeit eines Umschaltsignales (US) entweder das nicht invertierte oder das invertierte Binärsignal ($U_B^+, U_B^-$) des Komparators an seinen Ausgang legt,

d) einer Auswertelogik (AL), die mit dem Ausgang des Multiplexers (M) verbunden ist und ankommende Impulse (P) in einem bestimmten Zeitintervall (T) zählt, wobei die Summe der Impulse (P) pro Zeitintervall (T) am Ausgang der Auswertelogik (AL) zur Weiterverarbeitung abgreifbar ist,

e) einem in der Zählrichtung umschaltbaren Zähler (Z), dessen Zählimpulseingang (ZI) mit dem Ausgang des Multiplexers (M) und dessen Zählerausgang (ZA) mit dem Digitaleingang (D) eines Digital-Analog-Wandlers (DA) verbunden ist, wobei der Zähler (Z) über einen Überlaufausgang (UE) ein Überlaufsignal ausgibt, wenn jeweils eine vorgebbare obere oder untere Zählgrenze erreicht ist,

f) einem bistabilen Schalter (FF), der bei jedem Überlaufsignal des Zählers (Z) ein Umschaltsignal (US) abgibt, wobei das Umschaltsignal (US) die Umschaltung zwischen positiver und negativer Verstärkung des Verstärkers (V), die Umschaltung der Zählrichtung des Zählers (Z) über dessen Umschalteingang (UD), sowie die Umschaltung des Multiplexers (M) bewirkt.

5. Einrichtung nach Anspruch 4, **dadurch gekennzeichnet**, daß zwischen Multiplexer (M) und Auswertelogik (AL) eine Impulsüberwachung (PU) vorgesehen ist, die in Abhängigkeit von den Ausgangssignalen (P) des Multiplexers (M) eine Folge von Zusatzimpulsen (P) abgeben kann, wobei der Zählimpulseingang des Zählers (Z) mit dem Ausgang der Impulsüberwachung (PU) verbunden ist.

6. Einrichtung nach den Ansprüchen 4 und 5 zur Wandlung der erzeugten Pulse (P) in eine Gleichspannung ($U_E'$) über eine Regelstrecke bestehend aus:

a) einem monostabilen Präzisionsschalter (MF) der mit einem Oszillator (OS) verbunden ist und der zu jedem Puls (P) einen Impuls (IP) mit konstanter Pulsbreite erzeugt,

b) einem Schalter (SC) der die vom monostabilen Präzisionsschalter (MF) ankommenden Impulse (IP) mit konstanter Amplitude an einen Tiefpaß (TP) weitergibt,

c) einem Vergleicher (VG2) der aus der Gleichspannung ($U_E'$) am Ausgang des Tiefpasses (TP) und aus der angehobenen Eingangsspannung ($U_E^+$) eine Differenzspannung ($U_{dE}$) bildet,

d) einem Regler ($R_J$) der die Differenzspannung ($U_{dE}$) regelt und

e) einem Vergleicher (VG1) zwischen dem Ausgang des Verstärkers (V) und der verbleibenden Regelstrecke des Spannungs-Frequenz-Wandlers, der aus der Summe der verstärkten angehobenen Eingangsspannung ($U_E^+$) am Ausgang des Verstärkers (V) und aus der geregelten Differenzspannung ($U_{dE}$) am Ausgang des Reglers ($R_J$) eine Regelgröße ($U_R$) für die verbleibende Regelstrecke des Spannungs-Frequenz-Wandlers bildet.

7. Einrichtung nach Anspruch 4, 5 oder 6, **dadurch gekennzeichnet**, daß die Auswertelogik (AL) über eine Übertragungsstrecke (ST) und eine Treiberstufe (T) an die verbleibende Einrichtung angeschlossen ist.

FIG 1

FIG 2

FIG 3

$U_J < U_A : "0"$

$U_J > U_A : "1"$

FIG 4

FIG 5

FIG 6

FIG 7

FIG 8

FIG 9

EP 0 387 685 A2